(19) **Europäisches Patentamt / European Patent Office / Office européen des brevets**

(11) **EP 3 839 741 B1**

(12) **FASCICULE DE BREVET EUROPEEN**

(45) Date de publication et mention de la délivrance du brevet:
**02.08.2023  Bulletin 2023/31**

(21) Numéro de dépôt: **20214014.1**

(22) Date de dépôt: **15.12.2020**

(51) Classification Internationale des Brevets (IPC):
*G06F 11/00* (2006.01)    *G06F 11/10* (2006.01)
*G06F 11/07* (2006.01)    *G11C 29/44* (2006.01)
*G11C 29/52* (2006.01)

(52) Classification Coopérative des Brevets (CPC):
**G06F 11/008; G06F 11/0754; G06F 11/1004;**
**G11C 29/52;** G11C 2029/0411

(54) **SYSTEME ELECTRONIQUE COMPORTANT UN DISPOSITIF D'ESTIMATION DE DEFAUTS D'UNE MEMOIRE ELECTRONIQUE SOUMISE AUX CONDITIONS DE VOL A HAUTE ALTITUDE**

ELEKTRONISCHES SYSTEM MIT EINER VORRICHTUNG ZUR FEHLERABSCHÄTZUNG EINES ELEKTRONISCHEN SPEICHERS, DER HÖHENFLUGBEDINGUNGEN AUSGESETZT IST

ELECTRONIC SYSTEM COMPRISING A DEVICE FOR ESTIMATING DEFECTS OF AN ELECTRONIC MEMORY SUBJECTED TO HIGH-ALTITUDE FLIGHT CONDITIONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2019  FR 1914561**

(43) Date de publication de la demande:
**23.06.2021  Bulletin 2021/25**

(73) Titulaire: **THALES**
**92400 Courbevoie (FR)**

(72) Inventeurs:
• **DERVIN, Patrick**
**33700 MERIGNAC (FR)**
• **CAUDOUX, Frédéric**
**33700 MERIGNAC (FR)**
• **MURZEAU, Jean**
**33700 MERIGNAC (FR)**

(74) Mandataire: **Atout PI Laplace**
**Immeuble "Visium"**
**22, avenue Aristide Briand**
**94117 Arcueil Cedex (FR)**

(56) Documents cités:
FR-A1- 2 922 037     GB-A- 2 567 190
US-A1- 2016 224 412     US-A1- 2019 155 671

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

L'invention se situe dans le domaine technique des mémoires électroniques embarquées sur aéronef. Lorsqu'un aéronef évolue à haute altitude, typiquement de 10 000 mètres et au-delà, les équipements électroniques et, en particulier les mémoires électroniques, sont exposées aux particules à haute énergie, typiquement des neutrons, susceptibles d'altérer le fonctionnement des composants électroniques primaires. Lorsque l'effet est suffisant pour entraîner un changement d'état du composant, il est appelé « Single Effect Upset » ou « SEU » ou « Multiple Effect Upset » ou « MEU ». Ainsi, un « 0 » électronique peut se transformer en « 1 » électronique et vice-versa.

Plus précisément, le domaine technique de l'invention est celui des mémoires volatiles de type « RAM », acronyme signifiant « Random Access Memory » et de leurs dérivées et des mémoires non volatiles de type « ROM », acronyme signifiant « Read Only Memory ».

On comprend que ce problème d'altération des mémoires est très sensible dans la mesure où les équipements avioniques sont critiques pour assurer la sécurité de l'aéronef et de ses passagers. Ces équipement sont, par conséquent, soumis à des exigences très sévères de certification.

Par ailleurs, l'évolution des technologies électroniques permet une miniaturisation de plus en plus importante des composants et, par conséquent, les rend plus sensibles à ces perturbations.

Il est donc important de connaître le nombre de cases ou de mots d'une mémoire qui sont affectées par un SEU ou un MEU sur une durée donnée en conditions réelles d'utilisation. Ce taux est connu sous la dénomination de « FIT rate », acronyme signifiant « Failure In Time rate » ou taux de défaillance par unité de temps. Il est important de connaitre ce taux lorsque la mémoire est à l'intérieur d'un calculateur et dans les conditions réelles d'utilisation dans l'avion. Cette caractérisation est différente de celle effectuée par le fabricant en conditions de laboratoire.

Pour déterminer ce taux, deux approches sont possibles. Dans la première approche, on parcourt exhaustivement toute la mémoire pour détecter les altérations et les compter. Cette première approche donne un résultat précis mais l'impact sur la performance est très élevé car la détection est intrusive. Les accès dédiés à la détection s'ajoutent aux accès opérationnels, réduisant ainsi la bande passant utile de la mémoire ou nécessitant une électronique plus complexe comme, par exemple, une mémoire double port, solution qui n'est possible que pour des mémoires de petite taille. Cet inconvénient est généralement rédhibitoire.

Dans la seconde approche, on ne détecte les altérations et on ne les compte que lors des lectures opérationnelles de la mémoire. Cette seconde approche est beaucoup plus simple à mettre en oeuvre que la première mais elle présente deux inconvénients principaux :

- le parcours exhaustif de la mémoire n'est pas garanti pendant la période d'observation ;
- il existe un risque de comptabiliser une même altération plusieurs fois quand les accès opérationnels lisent plusieurs fois la même case mémoire pendant la période d'observation, ce qui est une situation très courante, faussant ainsi les mesures.

Pour corriger le second inconvénient, certains circuits intégrés comme les circuits « FPGA », acronyme signifiant « Field Programmable Gate Arrays » ou les circuits « ASIC », acronyme de « Application-Specific Integrated Circuit » corrigent le contenu de la mémoire lorsque l'altération est détectée, ce qui garantit qu'elle n'est comptabilisée qu'une seule fois. Cependant, ces dispositifs de correction de la mémoire sont très complexes et ont un impact sur les performances car le dispositif de correction bloque le flux de lecture pendant le temps nécessaire à la réécriture de la donnée corrigée.

Par conséquent, les solutions existantes sont soit trop gourmandes en temps d'exécution soit partiellement erronées. Le document US 2019/155671 A1 décrit un système électronique pour applications aéronautiques comportant au moins une mémoire électronique comprenant une première pluralité de mots et un système de détection d'erreurs. Il comporte un dispositif de comptage d'erreurs comprenant: • un registre comprenant une seconde pluralité (NBR) de bits, une adresse d'un bit étant associée à au moins un mot; ainsi que • des moyens de remise à zéro du registre à la fin de la période de temps donnée. Le document FR 2 922 037 A1 décrit un procédé de sécurisation de données en mémoire vive utilisant par mot mémoire un bit de parité unique permettant de détecter une erreur qui correspond à une information de parité instantanée de la donnée. U

Un objet de l'invention est de remédier au problème de comptabiliser une même altération plusieurs fois quand les accès opérationnels lisent plusieurs fois la même case mémoire pendant la période d'observation, sans altérer les temps de lecture et sans apporter de modifications substantielles aux systèmes électroniques surveillés. Plus précisément, le système électronique pour applications aéronautiques selon l'invention comporte au moins une mémoire électronique comprenant une première pluralité de mots et un système de détection d'erreurs desdits mots, comportant un dispositif de comptage d'erreurs comprenant :

- un registre comportant une seconde pluralité de bits, une adresse d'un bit étant associée à au moins un mot ;
- des moyens d'indexation du bit associé audit mot lorsque le système de détection d'erreurs signale une altération dudit mot, l'indexation dudit bit étant unique dans une période de temps donnée, quel que soit le nombre de fois où l'altération dudit mot est détectée par le système de détection d'erreurs dans ladite période de temps donnée ;

- des moyens de remise à zéro du registre à la fin de la période de temps donnée.

Avantageusement, la seconde pluralité est égale à la première pluralité, le nombre de bits du registre étant strictement égal au nombre de mots de la mémoire, chaque adresse correspondant à un seul mot.

Avantageusement, la seconde pluralité est un sous-multiple de la première pluralité, les mots étant répartis par groupe de même taille, chaque groupe de mots étant associé à une adresse unique de bit.

Avantageusement, les différents mots d'un même groupe associés à une adresse unique de bit ont des numéros d'adresse qui se suivent.

Avantageusement, les différents mots d'un même groupe associés à une adresse unique de bit sont choisis de façon à être séparés physiquement dans la mémoire électronique.

D'autres caractéristiques, détails et avantages de l'invention ressortiront à la lecture de la description faite en référence aux dessins annexés donnés à titre d'exemple et qui représentent, respectivement :

[Fig.1] une illustration du système électronique selon l'invention ;
[Fig.2] une illustration d'un premier mode de fonctionnement du système selon l'invention ;
[Fig.3] une illustration d'un second mode de fonctionnement du système selon l'invention.

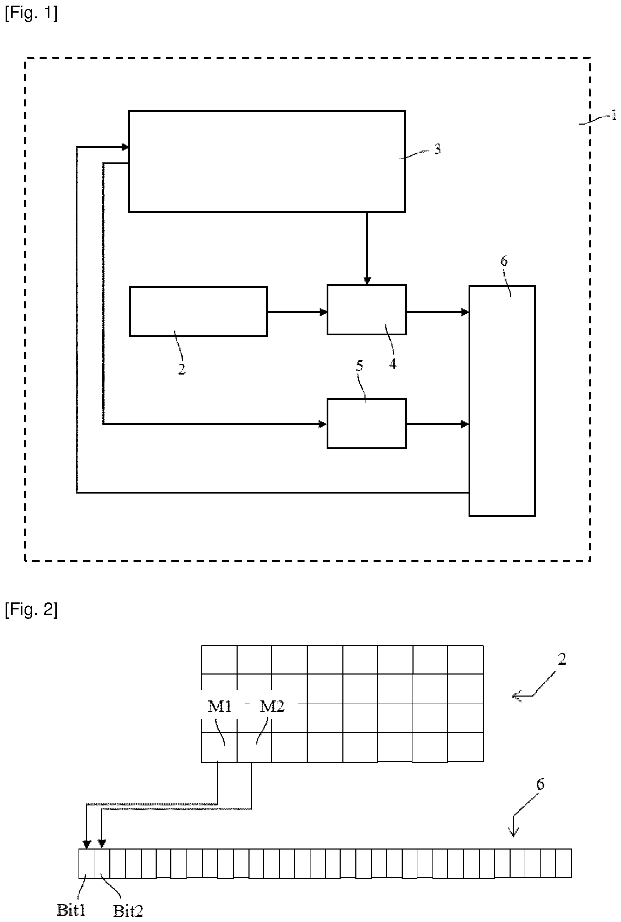

A titre d'exemple, la figure 1 représente un système électronique 1 embarqué pour applications aéronautiques selon l'invention. Ce système peut être de toute nature. Sur cette figure, seuls les éléments essentiels au fonctionnement du dispositif d'estimation et de comptage des défauts de la mémoire électronique ont été représentés. Les flèches indiquent les relations entre les différents éléments. Le système électronique est notamment un calculateur électronique embarqué sur aéronef.

Le système électronique 1 comporte au moins une mémoire électronique 2. Le dispositif selon l'invention fonctionne avec tous types de mémoire. Le système est adapté aux mémoires électroniques susceptibles d'être sensibles aux particules ou aux rayonnements cosmiques à haute énergie présents à des altitudes supérieures ou égales à 10 000 mètres.

A titre d'exemple, cette mémoire peut être une RAM ou une ROM ou tout type de mémoire sensible aux rayonnements à haute altitude. Dans la suite, on note T le nombre de mots contenus dans la mémoire 2.

Généralement la taille des mémoires est une puissance de deux. Néanmoins, le dispositif fonctionne aussi bien avec une taille mémoire qui n'est pas une puissance de deux. La mémoire est classiquement adressée par un bus de données.

Le système électronique 1 comporte un dispositif de comptage d'erreurs de ladite mémoire. Ce dispositif de comptage comprend les différents éléments détaillés ci-dessous.

Un processeur électronique 3. Il gère l'ensemble des moyens permettant de déterminer le nombre de mots de la mémoire électronique 2 qui comportent une erreur. Ce processeur peut être autonome ou être une fonction dédiée gérée par un calculateur électronique comportant d'autres applications Le processeur peut éventuellement aussi être un automate HW ou séquenceur câblé.

Un estimateur d'erreur 4, connu également sous la terminologie « EDC », signifiant « Error Detection Code ». Il existe différentes techniques permettant de détecter des erreurs dans un mot codé en binaire. Elles sont toutes basées sur l'ajout d'informations redondantes. En cas d'erreur dans le mot, la redondance est conçue pour que cette erreur entraîne une incohérence de certains paramètres et qu'ainsi, l'erreur soit détectée. Généralement, ces systèmes sont conçus pour permettre non seulement la détection, mais également la correction des erreurs détectées.

Un registre 6 comportant un nombre NBR de bits. Ce registre peut être remis à zéro par le dispositif 5. Cette remise à zéro peut être faite par logiciel ou par un automate électronique. Le dispositif selon l'invention peut s'adapter à tous types de taille de mémoire. Il est nécessaire cependant d'adapter la taille du registre qui lui est lié en fonction de la taille de la mémoire.

Idéalement, le nombre NBR est égal à celui de la taille mémoire T. Chaque bit du registre est alors associé à un et un seul mot de la mémoire. La figure 2 illustre ce principe. La mémoire 2 comporte 32 mots et le registre 6 comporte 32 bits. Ainsi le premier mot M1 est associé au bit 1, le mot suivant M2 au bit 2 et ainsi de suite.

Lorsque la taille de la mémoire est très importante, un bit peut être associé à plusieurs mots de la mémoire de façon à réduire le nombre de bits du registre. On réduit également la durée de lecture du registre de ce même facteur. Si on note G l'ensemble des mots associés à un même bit, alors le nombre NBR peut être diminué de ce facteur G et on a la relation simple :

$$NBR = \frac{T}{G}$$

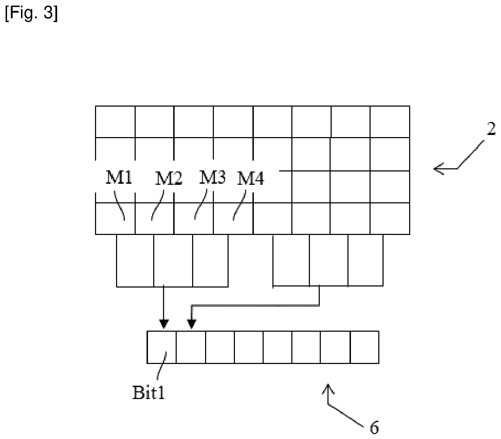

. La figure 3 illustre ce principe. La mémoire 2 comporte 32 mots et le registre 6 comporte 8 bits. Des groupes de 4 mots adressent donc le même bit comme on le voit sur cette figure 3. Ainsi les premiers mots M1, M2, M3 et M4 sont associés au bit 1 et ainsi de suite.

La taille d'un groupe est généralement une puissance de deux. Il est à noter qu'il n'est pas nécessaire que la taille de la mémoire soit elle-même une puissance de deux.

Le fonctionnement du système électronique est cyclique. La durée du cycle dépend de la technologie et de la taille de la mémoire 2, de la précision souhaitée, de l'altitude de vol de l'aéronef qui porte le système embarqué comportant ladite mémoire.

Au début d'un cycle ou à la fin d'un cycle, le processeur 3 commande la remise à zéro du registre 6 au moyen de la commande de remise à zéro 5.

Ensuite, chaque fois que, pendant la durée du cycle, un mot de la mémoire 2 est utilisé, il est également scruté par l'estimateur d'erreurs 4. Si l'estimateur ne constate aucune erreur, alors le bit du registre correspondant audit mot de la mémoire reste à 0.

Si l'estimateur d'erreurs constate une erreur sur ce mot, alors le bit du registre passe à 1 s'il était à 0. Si le bit était déjà à 1, alors, il reste à 1. On a vu que la taille du registre peut être soit égale à la taille de la mémoire, soit être un sous-multiple. Lorsque la taille du registre est égale à la taille mémoire, la conservation du bit du registre à 1 permet d'éviter que, lorsqu'un mot de la mémoire comportant une erreur est lu plusieurs fois, l'estimateur d'erreurs l'indexe plusieurs fois dans le registre.

Lorsque la taille du registre est un sous-multiple de la taille de la mémoire, cela signifie qu'un groupe de mots associés à un bit de registres n'est comptabilisé qu'une seule fois, même si plusieurs mots différents de ce groupe comportent des erreurs. Cette disposition entraîne une simple diminution de la résolution, qui correspond au fait que la taille du registre est inférieure à la taille de la mémoire.

Lorsque la durée du cycle est écoulée, la totalité du registre est lue par le processeur électronique pour un traitement ultérieur, soit à des fins de statistiques, soit à des fins de gestion de mémoire. Bien entendu, il est possible de traiter simultanément une pluralité de mémoires.

La géométrie interne des mémoires est rarement connue pour des questions relevant du secret industriel concernant l'implantation des mémoires et on ne connait donc pas la relation qui existe entre les adresses des mots et la position géométrique des mots sur la puce qui porte la mémoire. Dans ce cas, les groupes peuvent être choisis arbitrairement. Par exemple, on peut, pour simplifier la lecture, choisir des groupes de mots dont les adresses sont contiguës.

Si l'on connait l'emplacement physique des mots à l'intérieur de la puce, il est intéressant de choisir, pour chaque groupe, des mots qui ne soient pas physiquement contigus. Si la géométrie de la mémoire est faite de sorte que deux adresses contiguës ne sont pas rangées au même emplacement physique, une première solution simple consiste à choisir des groupes de mots d'adresses contiguës comme précédemment.

Si les adresses contiguës se suivent physiquement sur la mémoire, une seconde solution consiste à étaler chaque groupe sur toute la mémoire en regroupant des mots espacés de G mots. Par exemple, le premier groupe contiendra les G mots de numéros d'adresses 0, (G-1), (2G - 1), (3G - 1) et ainsi de suite, le deuxième groupe contiendra les G mots de numéros d'adresses 1, G, 2G, 3G, et ainsi de suite, le troisième groupe contiendra les G mots de numéros d'adresses 2, (G+1), (2G + 1), (3G + 1) et ainsi de suite.

Dans une variante de réalisation, l'étalement peut avantageusement être réalisé par sous-groupes de mots au lieu d'être fait mot par mot.

Ce regroupement est avantageux quand l'application en cours utilise seulement une partie de la mémoire. En général, dans un tel cas, seule la partie basse de la mémoire est utilisée et le regroupement précédent améliore la granularité.

Par exemple, si l'on n'utilise que la moitié basse de la mémoire qui correspond aux adresses numérotées de 0 à T/2 - 1, en utilisant un regroupement contigu, seuls les premiers groupes sont sollicités. En effet, la deuxième moitié des groupes est associée à des mots mémoire qui ne sont jamais lus. La granularité est alors égale à G.

Avec le regroupement étalé, tous les groupes sont sollicités car ils contiennent tous des mots dans la partie basse de la mémoire. De plus, c'est exactement la moitié des mots de chaque groupe qui est sollicitée, et l'autre moitié des mots des groupes n'est jamais sollicitée. Du point du vue du comptage, tout se passe comme si les groupes étaient deux fois plus petits. La granularité est alors G/2. On gagne ainsi un facteur 2 par rapport au cas précédent.

Comme on l'a dit, il est intéressant que la taille G des groupes soit une puissance de deux. En effet, dans ce cas, on simplifie le codage des adresses qui est effectué en binaire.

Les avantages du dispositif de détection selon l'invention sont les suivants. Pour une application, il traite la totalité des mots de la mémoire nécessaires à cette application et seulement ceux-là.

Quel que soit la taille du registre qui comptabilise les altérations, celles-ci ne sont comptabilisée qu'une seule fois, même si le mot altéré est lu plusieurs fois au cours de l'application. On évite ainsi des erreurs d'interprétation concernant les dommages causés à la mémoire.

Le dispositif ne modifie pas les performances du système électronique qui comporte la mémoire et en particulier les temps d'accès à la mémoire. Enfin, il ne nécessite que des adaptations mineures du système électronique qui sont très faciles à mettre en oeuvre.

**Revendications**

1. Système électronique (1) pour applications aéronautiques comportant au moins une mémoire électronique (2) comprenant une première pluralité (T) de mots, un système de détection d'erreurs (4), comportant un dispositif de comptage d'erreurs comprenant :

    - un registre (6) comportant une seconde pluralité (NBR) de bits, une adresse d'un bit étant associée à au moins un mot ;
    - des moyens d'indexation du bit associé audit mot lorsque le système de détection d'erreurs signale une altération dudit mot, l'indexation dudit bit étant unique dans une période de temps donnée, quel que soit le nombre de fois où l'altération dudit mot est détectée par le système de détection d'erreurs dans ladite période de temps donnée ;
- des moyens de remise à zéro (5) du registre à la fin de la période de temps donnée.

2. Système électronique selon la revendication 1, **caractérisé en ce que** la seconde pluralité est égale à la première pluralité, le nombre de bits du registre étant strictement égal au nombre de mots de la mémoire, chaque adresse correspondant à un seul mot.

3. Système électronique selon la revendication 1, **caractérisé en ce que** la seconde pluralité est un sous-multiple de la première pluralité, les mots étant répartis par groupe (G) de même taille, chaque groupe de mots étant associé à une adresse unique de bit.

4. Système électronique selon la revendication 3, caractérisé en ce les différents mots d'un même groupe associés à une adresse unique de bit ont des numéros d'adresse qui se suivent.

5. Système électronique selon la revendication 3, caractérisé en ce les différents mots d'un même groupe associés à une adresse unique de bit sont choisis de façon à être séparés physiquement dans la mémoire électronique.

**Patentansprüche**

1. Elektronisches System (1) für Luftfahrtanwendungen mit mindestens einem elektronischen Speicher (2), der eine erste Vielzahl (T) von Wörtern umfasst, einem Fehlererkennungssystem (4), das eine Fehlerzählvorrichtung aufweist, Folgendes umfassend:

- ein Register (6), das eine zweite Vielzahl (NBR) von Bits aufweist, wobei eine Adresse eines Bits mindestens einem Wort zugeordnet ist;
- Mittel zur Indizierung des dem Wort zugeordneten Bits, wenn das Fehlererkennungssystem eine Änderung des Wortes meldet, wobei die Indizierung des Bits in einer gegebenen Zeitperiode einzigartig ist, unabhängig von der Anzahl von Malen, in denen die Änderung des Wortes durch das Fehlererkennungssystem in der gegebenen Zeitperiode erkannt wird;
- Mittel zum Zurücksetzen auf null (5) des Registers am Ende der gegebenen Zeitperiode.

2. Elektronisches System nach Anspruch 1, **dadurch gekennzeichnet, dass** die zweite Vielzahl gleich der ersten Vielzahl ist, wobei die Anzahl von Bits des Registers strikt gleich der Anzahl von Wörtern des Speichers ist, wobei jede Adresse einem einzigen Wort entspricht.

3. Elektronisches System nach Anspruch 1, **dadurch gekennzeichnet, dass** die zweite Vielzahl ein Untervielfaches der ersten Vielzahl ist, wobei die Wörter in Gruppen (G) gleicher Größe aufgeteilt sind, wobei jede Gruppe von Wörtern einer einzigartigen Bitadresse zugeordnet ist.

4. Elektronisches System nach Anspruch 3, **dadurch gekennzeichnet, dass** die verschiedenen Wörter einer gleichen Gruppe, die einer einzigartigen Bitadresse zugeordnet sind, aufeinanderfolgende Adressnummern aufweisen.

5. Elektronisches System nach Anspruch 3, **dadurch gekennzeichnet, dass** die verschiedenen Wörter einer gleichen Gruppe, die einer einzigartigen Bitadresse zugeordnet sind, so gewählt sind, dass sie im elektronischen Speicher physisch getrennt sind.

**Claims**

1. An electronic system (1) for aeronautical applications having at least one electronic memory (2) comprising a first plurality (T) of words, an error detection system (4), having an error counting device comprising:

- a register (6) having a second plurality (NBR) of bits, an address of one bit being associated with at least one word;
- means for indexing the bit associated with said word when the error detection system signals an alteration of said word, the indexing of said bit being unique in a given period of time, regardless of the number of times the alteration of said word is detected by the error detection system in said given time period;
- means for resetting (5) the register at the end of the given period of time.

2. The electronic system according to claim 1, **characterised in that** the second plurality is equal to the first plurality, the number of bits of the register being strictly equal to the number of words of the memory, each address corresponding to a single word.

3. The electronic system according to claim 1, **characterised in that** the second plurality is a sub-multiple of the first plurality, the words being distributed by group (G) of the same size, each group of words being associated with a unique bit address.

4. The electronic system according to claim 3, **characterised in that** the different words of a same group associated with a unique bit address have consecutive address numbers.

5. The electronic system according to claim 3, **characterised in that** the different words of a same group associated with a single bit address are chosen so as to be physically separated in the electronic memory.

[Fig. 1]

[Fig. 2]

[Fig. 3]

**EP 3 839 741 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2019155671 A1

- FR 2922037 A1